# EUROPEAN PATENT SPECIFICATION

(11) **EP 3 089 828 B1**
(45) Date of publication and mention of the grant of the patent: **15.11.2017**
(21) Application number: 14864979.1
(22) Date of filing: 29.12.2014
(51) Int. Cl.: B06B 1/06

(54) **ULTRASOUND TRANSDUCER STACK**
ULTRASCHALLWANDLERSTAPEL
PILE DE CAPTEURS ULTRASONORES

(30) Priority: 31.12.2013 US 201314144799
(43) Date of publication of application: 09.11.2016
(73) Proprietor: Acist Medical Systems, Inc., Eden Prairie, MN 55344 (US)
(72) Inventor: BAUTISTA, Rick, Palo Alto, CA 94301 (US); WATERS, Kendall R., Sammamish, WA 98029 (US)
(74) Representative: Pistolesi, Roberto
(86) International application number: PCT/US2014/072514
(87) International publication number: WO 2015/116340

(56) References cited:
- EP-A2- 2 610 860
- US-A1- 2004 190 377
- US-A1- 2013 090 561
- US-A1- 2013 127 297

## Description

### FIELD

The present application relates generally to transducer stacks for ultrasound transducers. The application further relates to ultrasound transducer stacks for transducers used for medical imaging.

### BACKGROUND

In medical ultrasound imaging, transducer performance plays a key role in ultrasound image quality. One common type of ultrasound imaging system is the intravascular ultrasound (IVUS) system. With this system, an IVUS transducer is provided on a distal end of a catheter and the catheter is inserted into blood vessels. Common imaging targets for IVUS systems are coronary artery walls. As such, the transducers and catheters must have a small size that fits within coronary arteries. IVUS transducers are typically single-element transducers, which are small enough to fit within coronary arteries. However, single-element ultrasound transducers have inherent limitations in performance of both transducer sensitivity and bandwidth. IVUS transducers are also designed for a single use only. Once the IVUS procedure is completed, the IVUS transducer is thrown away. As such, there are cost constraints that limit the types of materials and processes that can be used to make IVUS transducers. Such transducers are known, for example, from US2013127297 which discloses an ultrasonic transducer which achieves a broad bandwidth using a textured matching layer.

It would be advantageous to have an improved single-element ultrasound transducer that has a wider bandwidth and an increased sensitivity. It would also be advantageous to have an improved single-use transducer that is cost-effective to manufacture.

### SUMMARY

Certain embodiments provide an ultrasound transducer stack. The ultrasound transducer stack is part of any type of ultrasound transducer, for example an IVUS transducer. The stack includes a backing layer, an active layer overlying the backing layer, and a matching layer overlying the active layer. The active layer has a surface comprising a plurality of textures.

Certain embodiments also provide a method of making an ultrasound transducer stack. The method can include steps of (a) forming a wafer and (b) dividing the wafer into segments, wherein each segment forms an ultrasound transducer stack. The step of forming a wafer can include steps of (i) providing a backing layer, (ii) providing an active layer overlying the backing layer, (iii) forming a plurality of textures on a surface of the active layer, and (iv) providing a matching layer over the surface of the active layer.

The matching layer has a first thickness region and a second thickness region, wherein the first thickness region has a larger thickness than a thickness of the second thickness region. The first thickness region extends into the plurality of textures and the second thickness region does not extend into the plurality of textures. In some cases, the first thickness region matches a first frequency and the second thickness region matches a second frequency, wherein the first frequency is higher than the second frequency. In one example, the first frequency is 60 MHz and the second frequency is 40 MHz. In other cases, the first thickness region has a thickness of ¾ λ and the second thickness region has a thickness of ¼ λ, wherein λ is a desired wavelength. The matching layer can also have a first thickness region/second region ratio. In some cases, the ratio is greater than 1:1 and in other cases the ratio is less than 1:1.

The plurality of textures in the active layer surface can have any desired surface shape, depth shape or pattern. In some embodiments, the plurality of textures each have a circular-shaped surface shape. Also, in some cases, the circular-shaped surface shapes can be provided as a pattern of rows of circles. Further, in some cases, the plurality of textures can each have a street-shaped surface shape. The street-shaped surface shapes can also be provided as a pattern of intersecting streets or as a pattern of non-intersecting streets. In other cases, the plurality of textures can have a square depth shape or a concave depth shape.

In some embodiments, the matching layer can also include a single matching layer or a first matching layer and a second matching layer. In some cases, the matching layer includes a first matching layer and a second matching layer, wherein the first matching layer defines extensions that extend into the plurality of textures and the second matching layer does not extend into the plurality of textures. Also, the first matching layer and the second matching layer can include the same material or different material.

### BRIEF DESCRIPTION OF DRAWINGS

The following drawings are illustrative of particular examples of the present invention and therefore do not limit the scope of the invention. The drawings are not to scale (unless so stated) and are intended for use in conjunction with the explanations in the following detailed description. Examples of the present invention will hereinafter be described in conjunction with the appended drawings, wherein like numerals denote like elements. Some embodiments will hereinafter be described in conjunction with the appended drawings, wherein like numerals denote like elements.
FIG. 1 is a side cross-section view of a portion of a transducer stack according to certain embodiments.
FIG. 2 is a perspective view of a portion of a transducer stack according to certain embodiments.
FIG. 3 is a side cross-section view of a portion of a transducer stack according to certain embodiments.
FIG. 4 is a perspective view of a portion of a transducer stack according to certain embodiments.
FIG. 5 is a side cross-section view of a portion of transducer stack according to certain embodiments.
FIG. 6 is a perspective section view of a portion of a transducer stack according to certain embodiments.
FIG. 7 is a side cross-section view of a portion of a transducer stack according to certain embodiments.
FIG. 8 is a perspective view of a portion of a transducer stack according to certain embodiments.
FIG. 9 is a side cross-section view of a portion of a transducer stack according to certain embodiments.
FIG. 10 is a perspective view of a portion of a transducer stack according to certain embodiments.
FIG. 11 is a side cross-section view of a portion of a transducer stack according to certain embodiments.
FIG. 12 is a perspective view of a portion of a transducer stack according to certain embodiments.
FIG. 13 is a perspective view of a portion of a transducer stack according to certain embodiments.
FIG. 14 is a perspective view of a portion of a transducer stack according to certain embodiments.
FIG. 15 is a perspective view of a wafer according to certain embodiments.

### DETAILED DESCRIPTION

The following detailed description is exemplary in nature and is not intended to limit the scope, applicability, or configuration of the invention in any way. Rather, the following description provides some practical illustrations for implementing examples of the present invention. Examples of constructions, materials, dimensions, and manufacturing processes are provided for selected elements, and all other elements employ that which is known to those of ordinary skill in the field of the invention. Those skilled in the art will recognize that many of the noted examples have a variety of suitable alternatives.

This application provides embodiments of a transducer stack for use in an ultrasound transducer. In some cases, the transducer stack is a stack designed for use in an intravascular ultrasound (IVUS) transducer, an intracardiac echocardiography transducer, and transesophageal imaging transducer. In further cases, the transducer stack is a stack designed for use in a single-element transducer. In yet other cases, the transducer stack is a stack designed for use in a single-use transducer. Also, in some cases, the transducer stack is a stack designed for use in a transducer that operates in thickness mode. Of course, skilled artisans will understand that this application is not limited to the above-referenced transducers.

Referring generally to the Figures, the application provides embodiments of an ultrasound transducer stack 10. The transducers stacks 10 are illustrated as having rectangular shapes. However, skilled artisans will understand that the transducer stacks 10 can instead have other shapes, including square, circle, and oval shapes.

The ultrasound transducer stack 10 includes a backing layer 12, an active layer 14 and a matching layer 16. The backing layer 12 typically serves as a base and the active layer 14 is provided over the backing layer 12. The matching layer 16 is in turn provided over the active layer 14. When used herein, the term "layer" can mean a single layer or a plurality of sublayers. For example, a matching layer 16 can be a single layer or include a plurality of sublayers each making up the matching layer.

The active layer 14 receives voltage and vibrates to generate a sound wave. The backing layer 12 absorbs vibrations from the active layer 14 and dampens them. The matching layer 16 improves the efficiency of the transducer stack 10 to transmit ultrasound vibrations into the surrounding medium and to receive ultrasound vibrations from the surrounding medium. For example, the matching layer 16 provides a better acoustic impedance match between the active layer 14 and the medium (e.g., saline) in which transducer stack is located.

The backing layer 12 includes at least one backing layer. In some cases, the backing layer 12 includes a single backing layer. In other cases, the backing layer 12 includes a plurality of backing sublayers. In certain cases, the backing layer 12 includes an electrically conductive epoxy, such as a tungsten-loaded epoxy.

The active layer 14 includes at least one active layer. In some cases, the active layer 14 includes a single active layer. In other cases, the active layer 14 includes a plurality of active layers. The active layer 14 can also include a single material or a composite material. In some cases, the active layer 14 comprises a single ceramic piezoelectric material such as lead zirconate titanate, commonly known as PZT. In certain cases, the active layer 14 comprises a material having an electrical impedance of less than 50 ohms, less than 40 ohms or perhaps less than 30 ohms, such as 27 ohms. In other cases, the active layer 14 comprises a composite material such as lead magnesium niobate-lead titanate single crystal, commonly known as PMN-PT and polymer.

The matching layer 16 includes at least one matching layer. In some cases, the matching layer 16 includes a single matching layer. In other cases, the matching layer 16 includes a plurality of matching layers. In some cases, the matching layer 16 comprises an electrically conductive epoxy, such as a silver-loaded epoxy.

The transducer stacks 10 can also include at least one electrode layer (not shown), which can be formed from metal such as gold, chrome and/or titanium. In one example, the transducer stack 10 can include a thin electrode layer positioned between the backing layer 12 and the active layer 14 and/or between the active layer 14 and the matching layer 16. For example, in some cases, the thickness can be between 0.005 microns to 0.3 microns, depending on the metal. The electrode layer generally facilitates electrical excitation of the active layer 14. The transducer stack 10 can also be electrically connected to a signal generator (not shown) to electrically excite the transducer stack 10. The transducer stack 10 can also be electrically connected to a receiver (not shown) to detect pressure fields that are converted to electrical signals by the transducer stack 10.

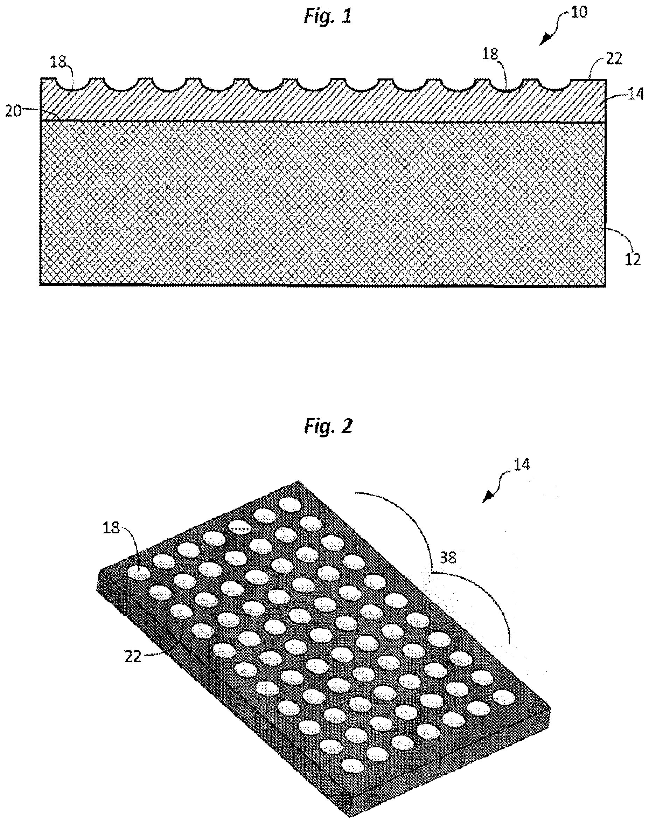

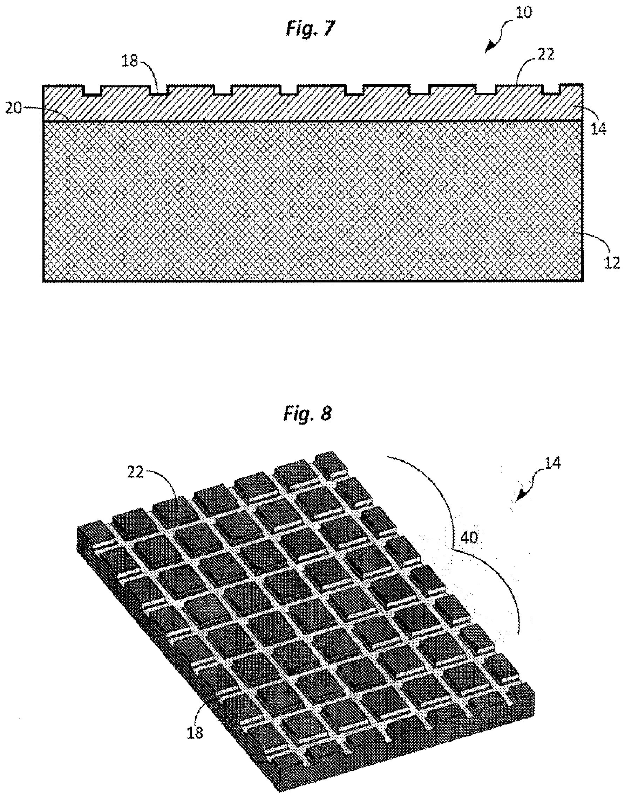

Referring to FIGs. 1 and 7, the active layer 14 includes a first surface 20 and a second surface 22. The first surface 20 faces (and sometimes directly contacts) the backing layer 12 and the second surface 22 faces the matching layer 16. The second surface 22 includes a plurality of textures 18. The textures 18 extend from the second surface 22 downward towards the first surface 20 as indentations, notches, recesses or cavities.

The textures 18 only partially extend downward from the second surface 22 towards the first surface 20. In some cases, active layer has a thickness or depth and the textures 18 extend downward for a depth of less than about ½ the depth of the active layer 14. In other cases, the textures 18 extend downward for a depth less than about 1/3 the depth of the active layer 14. As an example, the active layer 14 can have a thickness of about 50µm and the textures 18 can extend downward at a thickness of about 16 µm so that a thickness of about 34 µm remains under each texture 18. The depth of the textures 18 can be selected depending on the desired performance characteristics of the transducer stack 10.

The textures 18 also have a desired surface shape. The surface shape is a shape of the texture as viewed from a top of an active layer, such as shown in FIGs. 2, 8, 13 and 14. For example, the textures 18 can have a circular, oval, square, rectangular or street surface shape. The desired surface shape of the texture 18 is also selected depending on the desired performance characteristics of the transducer stack 10.

The textures 18 also have a desired depth shape. The depth shape is the shape of the textures as they extend downward from the second surface 22 towards the first surface 20. For example, the textures 18 can have a spherical, parabolic, concave, square or rectangular depth shape. For example, in the embodiment shown in FIG. 1, the textures 18 have a concave depth shape and form concavities in the second surface 22. In the embodiment shown in FIG, 7, the textures 18 have a rectangular depth shape. The depth shape of the texture 18 is selected depending on the desired performance characteristics of the transducer stack 10.

The textures 18 can also be provided as a pattern on the second surface 22 of the active layer 14. The textures 18 can be distributed uniformly or unevenly across the second surface 22. In some cases, the textures 18 are spaced apart by a desired distance, such as a distance of between 5/1000 inch to 10/1000 inch. In other cases, the textures 18 have a surface diameter or width of between 3/1000 inch to 10/1000 inch. The appropriate size, number and location of textures 18 on the second surface 22 can also vary depending on the specific application of the transducer stack 10.

In some cases, as best shown in FIG. 2, the textures 18 can be provided as a pattern of rows of circles 38. The row of circles 38 can include any desired number of rows and any desired number of circles within each row. Also, each row of circles can be spaced from another row of circles using any desired spacing dimensions. Finally, each circle within each row can be spaced from another circle using any desired spacing dimensions. The desired number of rows, number of circles, spacing between rows and spacing between circles can be selected depending on the desired performance characteristics of the transducer stack 10.

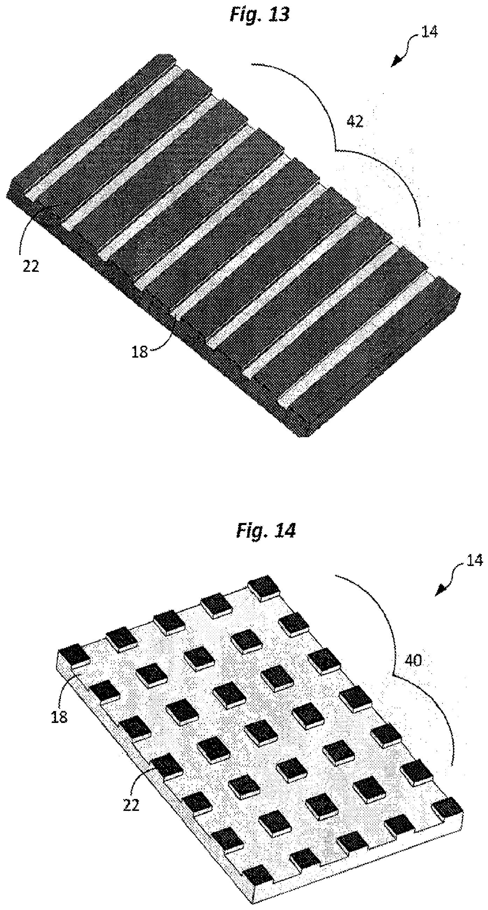

In other cases, the textures 18 are provided as a pattern of intersecting streets 40 that intersect one another, as best shown in FIGS. 8 and 14. The intersecting streets can intersect one another in any desired manner, such as a perpendicular manner or a diagonal or cross manner. In other cases, as shown in FIG. 13, the textures 18 are provided as a pattern of non-intersecting streets 42 that all run in a single direction. In these patterns, any desired number of streets can be provided.

Also, the streets can have any desired width. For example, the streets in FIG. 8 have a narrower width than the streets in FIG. 14. In some cases, the streets have a width between about 5/1000 inch and about 10/1000 inch. Likewise, the streets can have any desired depth. In certain cases, the streets have a depth of between approximately 10 microns and 20 microns. The depth will depend on the operating frequencies of the transducer. Further, the street depth can have any desired depth shape, such as a square depth shape, rectangular depth shape or a concave depth shape. The desired number of streets, width of streets, depth shapes and depth of streets can be selected depending on the desired performance characteristics of the transducer stack 10.

The textures 18 can be formed in the second surface 22 using any texture forming technique known in the art. In some cases, the texture forming technique is a subtractive technique. Suitable texture forming techniques include ablation, abrasion, blasting, machining, dicing, grinding and etching techniques. In some cases, a laser ablation technique can be used to create textures 18 in the second surface 22. For example, a CO₂ marking type laser, an eczema laser or a YAG type laser can be used to create textures 18 in the second surface 22.

A matching layer 16 is provided over the second surface 22 of the active layer 14. The matching layer has an outer surface 34 that faces away from the backing layer 12 and active layer 14. The matching layer 16 has a first thickness region 26 and a second thickness region 28. Each of the first thickness region 26 and the second thickness region 28 extend from the outer surface downward to the second surface 22 of the active layer 14.

The first thickness region 26 has a thickness that is larger than a thickness of the second thickness region 28. The first thickness region 26 also has extensions 24 that extend into the textures 18 created in the second surface 22 of the active layer 14. In other words, the extensions 24 "fill in" the textures 18. On the other hand, the second thickness region 28 does not extend into the textures 18 and instead overlies the second surface 22 of the active layer 14.

A matching layer having a first thickness region 26 and a second thickness region 28 allows the matching layer 16 to match at more than one ultrasound frequency. The first thickness region 26 matches at a first frequency and the second thickness region 28 matches at a second frequency. The first frequency is higher than the second frequency. In some embodiments, the first frequency is 60 MHz and the second frequency is 40 MHz. In other embodiments, the first frequency is a frequency in the range of 15-100 MHz and the second frequency is a frequency in the range of 1-15 MHz.

In some embodiments, the first thickness region 26 has a thickness of ¾ λ and the second thickness region 28 has a thickness of ¼ λ, wherein λ is a desired wavelength of the ultrasound vibration provided by the active layer. The use of such thickness regions 26, 28 widens the bandwidth of acoustic output that sends into the surrounding medium and widens the acoustic bandwidth that receives from waves that bounce back. The thickness regions 26, 28 also increase sensitivity to the returning waves.

The matching layer 16 can also be provided with a desired first thickness region/second thickness region ratio. The first thickness region/second thickness region ratio is selected depending on the desired performance characteristics of the transducer stack 10. For example, if the desired performance characteristic is a transducer stack 10 that generates equal pressure in the higher frequency and lower frequency, the first thickness region/second thickness region ratio can be 1:1. If the desired performance characteristic is a transducer stack 10 that generates more pressure in the higher frequency, the first thickness region/second thickness region ratio can be increased from 1:1 to 2:1, 3:1. 4:1 and so on. If the desired performance characteristic is a transducer stack 10 that generates more pressure in the lower frequency, the first thickness region/second thickness region ratio can be decreased from 1:1 to 1:2, 1:3, 1:4 and so on.

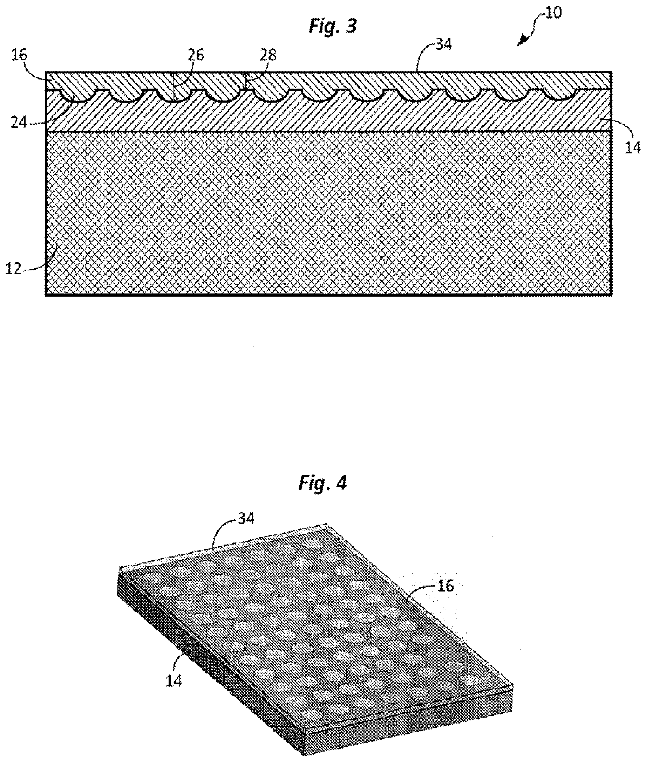

In some embodiments, as shown in FIGs. 3-4 and 9-10, the matching layer 16 is a single matching layer. Such a single matching layer 16 includes a single matching material. The matching layer can be a homogenous layer or perhaps a graded layer. In certain cases, the single matching layer 16 is a homogenous layer comprising an electrically conductive epoxy, such as a silver-loaded epoxy.

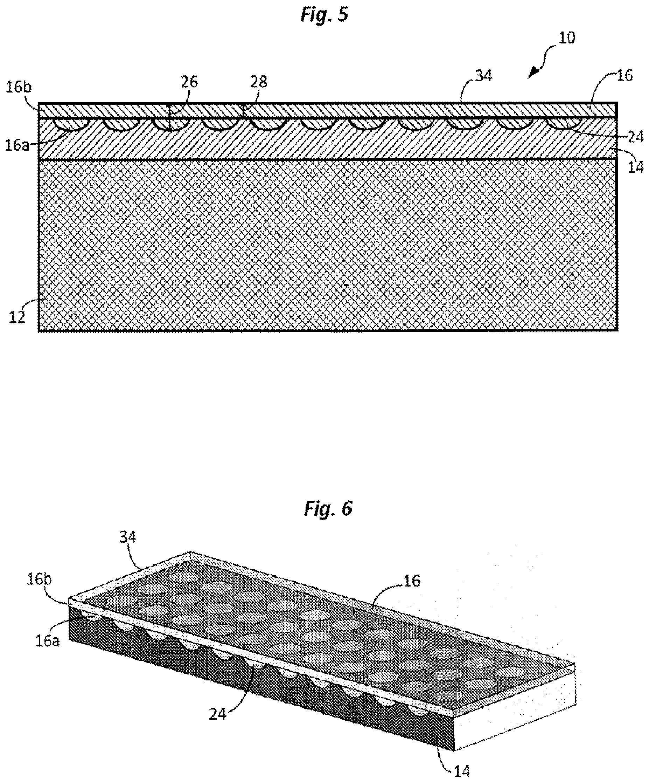

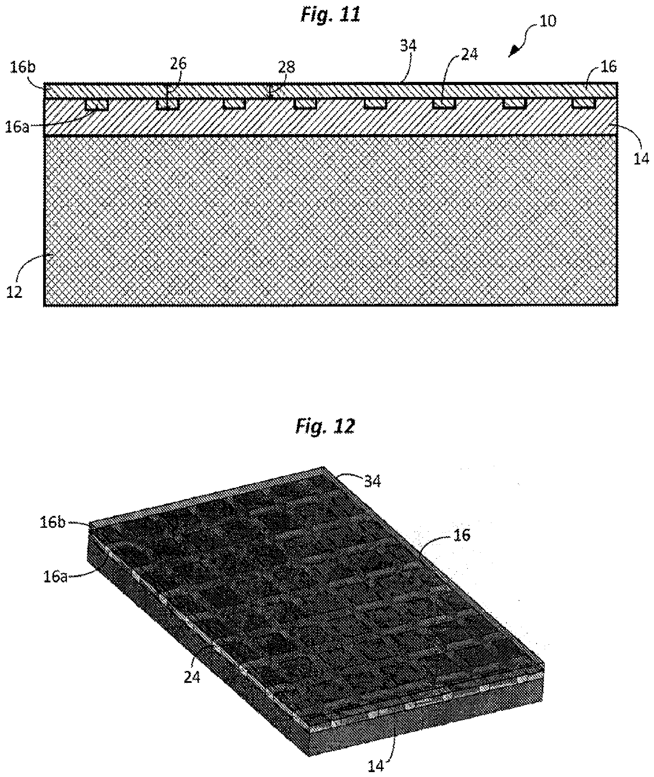

In other embodiments, as shown in FIGs. 5-6 and 11-12, the matching layer 16 includes a first matching layer 16a and a second matching layer 16b. Here, the first matching layer 16a defines the extensions 24 that extend into the textures 18 of the second surface 22 and the second matching layer 16b defines a layer overlying the extensions 24 and second surface 22. Certain portions of the second matching layer 16b directly contact the extensions 24 and other portions directly contact the second surface 22 of the active layer 14.

In some embodiments, the first matching layer 16a and the second matching layer 16b are formed of the same material. This same material can be provided in a single concentration for each matching layer 16a, 16b or in different concentrations. For example, in some cases, the first matching layer 16a comprises a material "X" in a first concentration and the second matching layer 16b comprises the material "X" in a different concentration. In some cases, each the first matching layer 16a and the second matching layer 16b comprise a silver-loaded epoxy having the same concentration. In other cases, the first matching layer 16a includes a silver-loaded epoxy having a first volume concentration of silver and the second matching layer 16b includes a silver-loaded epoxy having a second volume concentration of silver.

In other cases, the first matching layer 16a comprises a first material and the second matching layer 16b comprises a second material, wherein the first material is different from the second material. For example, in some cases, the first matching layer 16a includes a silver-loaded epoxy and the second matching layer 16b includes a different material such as poxy (i.e., unloaded epoxy), parylene, and poly(vinylidenefluoride-co-trifluoroethylene (or P(VDF-TrFE). In other cases, the first matching layer 16a includes the different material and the second matching layer 16b includes a silver-loaded epoxy.

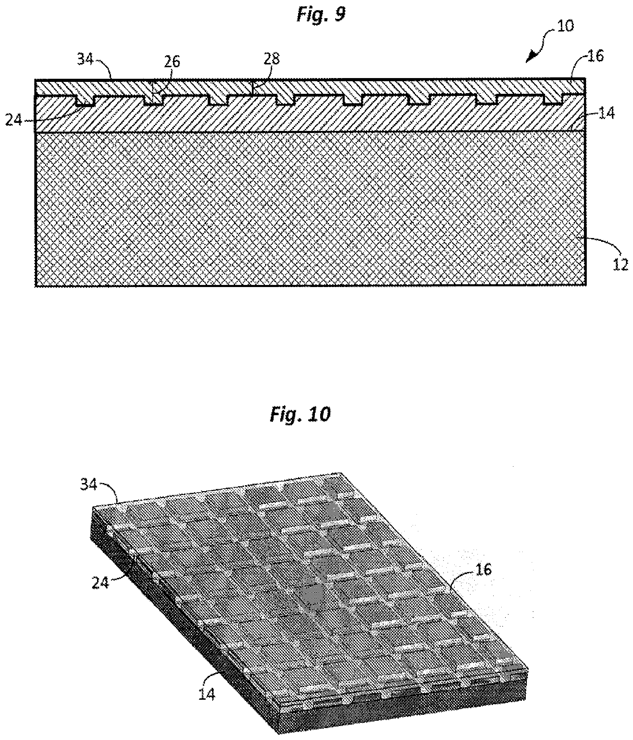

An exemplary embodiment will now be described with reference to FIG. 7. In this embodiment, active layer 14 is provided over the backing layer 12 at a thickness of about 50 µm. Next, textures 18 are created on the surface 22 of the active layer at a depth of about 17 µm. With reference to FIG. 9, a matching layer 16 is then provided over the active layer 14 such that the matching layer 16 has a first thickness region 26 extending into the textures 18 and a second thickness region 28 that does not extend into the active layer 14. The first thickness region 26 has a thickness of about 27 µm (wherein the active layer 14 directly beneath the first thickness region 26 has a thickness of about 34 µm) and the second thickness region 28 has at thickness of about 11 µm (wherein the active layer 14 directly beneath the second thickness region has at thickness of about 50 µm). The first thickness region 26 matches at a 60 MHz high frequency ¾ λ location and the second thickness region 28 matches at a 40 MHz low frequency ¼ λ location.

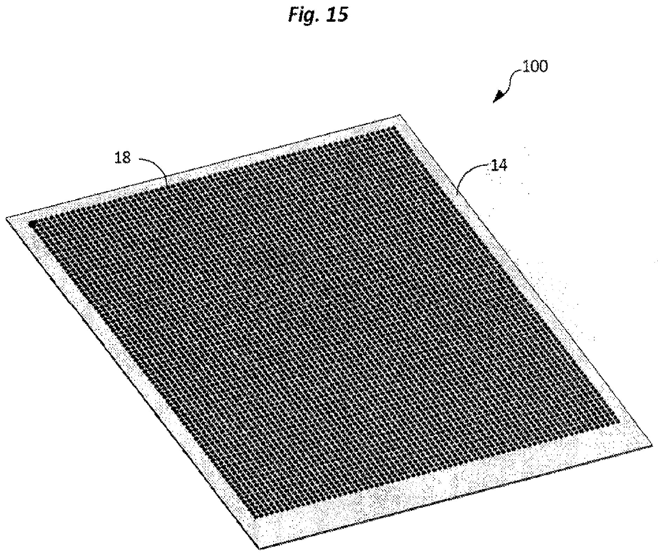

Some embodiments provide a method of manufacturing a transducer stack. The method first includes forming wafer 100 that includes steps of forming a backing layer 12, forming an active layer 14 over the backing layer 12, creating a plurality of textures 18 in the active layer 14, and forming a matching layer 16 over the plurality of textures 18. An exemplary wafer 100 is shown in FIG. 15. The method also includes cutting the wafer 100 into a plurality of segments, each segment being used as a transducer stack in an ultrasound transducer. Cutting techniques include machining, dicing, and etching.

Various examples of the invention have been described. Although the present invention has been described in considerable detail with reference to certain disclosed embodiments, the embodiments are presented for purposes of illustration and not limitation. Other embodiments incorporating the invention are possible. One skilled in the art will appreciate that various changes, adaptations, and modifications may be made without departing from the scope of the appended claims.

## Claims

1. An ultrasound transducer stack (10), comprising:
a backing layer (12);
an active layer (14) having a first surface (20) facing the backing layer (12) and a second surface (22) on a side of the active layer (14) opposite the first surface (20), wherein the second surface (22) comprises a plurality of textures (18) that only partially extend from the second surface (22) toward the first surface (20); and
a matching layer (16) facing the second surface (22) of the active layer (14), wherein the matching layer (16) has a first thickness region (26) and a second thickness region (28), wherein the first thickness region (26) has a larger thickness than a thickness of the second thickness region (28), wherein the first thickness region (26) extends into the plurality of textures (18) and the second thickness region (28) does not extend into the plurality of textures (18).

2. The ultrasound transducer stack (10) of claim 1 wherein the first thickness region (26) matches a first frequency and the second thickness region (28) matches a second frequency, wherein the first frequency is higher than the second frequency.

3. The ultrasound transducer stack of claim 2 wherein the first frequency is 60 MHz and the second frequency is 40 MHz.

4. The ultrasound transducer stack (10) of claim 1 wherein the first thickness region (26) has a thickness of ¾λ and the second thickness region (28) has a thickness of ¼λ, wherein λ is a desired wavelength.

5. The ultrasound transducer stack (10) of claim 1 wherein the matching layer (16) has a first thickness region/second thickness region ratio of greater than 1:1.

6. The ultrasound transducer stack (10) of claim 1 wherein the matching layer (16) has a first thickness region/second thickness region ratio of less than 1:1.

7. The ultrasound transducer stack (10) of claim 1 wherein the plurality of textures (18) each have a circular-shaped surface texture.

8. The ultrasound transducer stack (10) of claim 7 wherein the plurality of textures (18) is provided as a pattern of rows of circles.

9. The ultrasound transducer stack (10) of claim 1 wherein the plurality of textures (18) each have a square depth shape.

10. The ultrasound transducer stack (10) of claim 1 wherein the plurality of textures (18) each have a concave depth shape.

11. The ultrasound transducer stack (10) of claim 1 wherein the matching layer (16) includes a first matching layer (16a) and a second matching layer (16b).

12. The ultrasound transducer stack (10) of claim 11 wherein the first matching layer (16a) defines extensions (24) that extend into the plurality of textures (18) and the second matching layer (16b) does not extend into the plurality of textures (18).

13. The ultrasound transducer stack (10) of claim 11 wherein the first matching layer (16a) and the second matching layer (16b) comprise the same material.

14. The ultrasound transducer stack (10) of claim 11 wherein the first matching layer (16a) and the second matching layer (16b) comprise different material.

15. A method of making an ultrasound transducer stack, comprising steps of:
(a) forming a wafer (100) comprising steps of:
(i) providing a backing layer (12);
(ii) providing an active layer (14) overlying the backing layer (12);
(iii) forming a plurality of textures (18) on a surface of the active layer (14);
(iv) providing a matching layer (16) over the surface of the active layer (14), wherein the matching layer (16) has a first thickness region (26) and a second thickness region (28), wherein the first thickness region (26) has a larger thickness than a thickness of the second thickness region (28), wherein the first thickness region (26) includes extensions that extend into the plurality of textures (18) and fill in the plurality of textures (18) and the second thickness region (28) does not extend into the plurality of textures (18); and
(b) dividing the wafer (100) into segments, wherein each segment forms an ultrasound transducer stack (10).

## Patentansprüche

1. Ultraschall-Transducer-Stapel (10), welcher umfasst:
eine Trägerschicht (12);
eine aktive Schicht (14) mit einer ersten Oberfläche (20), die der Trägerschicht (12) gegenüberliegt, und einer zweiten Oberfläche (22) auf einer Seite der aktiven Schicht (14) abgewandt von der ersten Oberfläche, worin die zweite Oberfläche (22) mehrere Texturen (18) umfasst, die sich lediglich teilweise von der zweiten Oberfläche (22) auf die erste Oberfläche (20) zu erstrecken; und
eine Abgleichschicht (16), die der zweiten Oberfläche (22) der aktiven Schicht (14) gegenüberliegt, worin die Abgleichschicht (16) einen ersten Dickebereich (26) und einen zweiten Dickebereich (28) aufweist, worin der erste Dickebereich (26) eine größere Dicke aufweist als eine Dicke des zweiten Dickebereichs (28), worin sich der erste Dickebereich (26) in die mehreren Texturen (18) erstreckt und der zweite Dickebereich (28) sich nicht in die mehreren Texturen (18) erstreckt.

2. Ultraschall-Transducer-Stapel (10) nach Anspruch 1, worin der erste Dickebereich (26) zu einer ersten Frequenz passt und der zweite Dickebereich (28) zu einer zweiten Frequenz passt, worin die erste Frequenz höher ist als die zweite Frequenz.

3. Ultraschall-Transducer-Stapel (10) nach Anspruch 2, worin die erste Frequenz 60 MHz beträgt und die zweite Frequenz 40 MHz beträgt.

4. Ultraschall-Transducer-Stapel (10) nach Anspruch 1, worin der erste Dickebereich (26) eine Dicke von ¾λ aufweist und der zweite Dickebereich (28) eine Dicke von ¼λ aufweist, worin λ eine gewünschte Wellenlänge ist.

5. Ultraschall-Transducer-Stapel (10) nach Anspruch 1, worin die Abgleichschicht (16) ein Verhältnis erster Dickebereich/zweiter Dickebereich von größer als 1:1 aufweist.

6. Ultraschall-Transducer-Stapel (10) nach Anspruch 1, worin die Abgleichschicht (16) ein Verhältnis erster Dickebereich/zweiter Dickebereich von kleiner als 1:1 aufweist.

7. Ultraschall-Transducer-Stapel (10) nach Anspruch 1, worin die mehreren Texturen (18) jeweils eine ringförmig geformte Oberflächentextur aufweisen.

8. Ultraschall-Transducer-Stapel (10) nach Anspruch 7, worin die mehreren Texturen als ein Muster von Reihen von Ringen vorgesehen sind.

9. Ultraschall-Transducer-Stapel (10) nach Anspruch 1, worin die mehreren Texturen jeweils eine rechteckige Tiefenform aufweisen.

10. Ultraschall-Transducer-Stapel (10) nach Anspruch 1, worin die mehreren Texturen jeweils eine konkave Tiefenform aufweisen.

11. Ultraschall-Transducer-Stapel (10) nach Anspruch 1, worin die Abgleichschicht (16) eine erste Abgleichschicht (16a) und eine zweite Abgleichschicht (16b) umfasst.

12. Ultraschall-Transducer-Stapel (10) nach Anspruch 11, worin die erste Abgleichschicht (16a) Erweiterungen (24) definiert, die sich in die mehreren Texturen (18) erstrecken, und worin sich die zweite Abgleichschicht (16b) nicht in die mehreren Texturen (18) erstreckt.

13. Ultraschall-Transducer-Stapel (10) nach Anspruch 11, worin die erste Abgleichschicht (16a) und die zweite Abgleichschicht (16b) das gleiche Material umfassen.

14. Ultraschall-Transducer-Stapel (10) nach Anspruch 11, worin die erste Abgleichschicht (16a) und die zweite Abgleichschicht (16b) unterschiedliche Materialien umfassen.

15. Verfahren zur Herstellung eines Ultraschall-Transducer-Stapels, welches die Schritte umfasst,
(a) Bilden eines Wafers (100), was die Schritte umfasst:
(i) Bereitstellen einer Trägerschicht (12);
(ii) Bereitstellen einer aktiven Schicht (14) über der Trägerschicht (12);
(iii) Bilden mehrerer Texturen (18) auf einer Oberfläche der aktiven Schicht (14);
(iv) Bereitstellen einer Abgleichschicht (16) über der Oberfläche der aktiven Schicht (14), worin die Abgleichschicht (16) einen ersten Dickebereich (26) und einen zweiten Dickebereich (28) aufweist, worin der erste Dickebereich (26) eine größere Dicke aufweist als eine Dicke des zweiten Dickebereichs (28), worin der erste Dickebereich (26) Erweiterungen umfasst, die sich in die mehreren Texturen (18) erstrecken und die mehreren Texturen (18) ausfüllen, und worin sich der zweite Dickebereich (28) nicht in die mehreren Texturen (18) erstreckt; und
(b) Teilen des Wafers (100) in Segmente, worin jedes Segment einen Ultraschall-Transducer-Stapel (10) bildet.

## Revendications

1. Pile de capteurs ultrasonores (10), qui comprend :
une couche de support (12) ;
une couche active (14) qui possède une première surface (20) tournée vers la couche de support (12) et une seconde surface (22) sur un côté de la couche active (14) opposé à la première surface (20), la seconde surface (22) comprenant une pluralité de textures (18) qui s'étendent uniquement de manière partielle entre la seconde surface (22) et la première surface (20) ; et
une couche d'adaptation (16) tournée vers la seconde surface (22) de la couche active (14), la couche d'adaptation (16) ayant une zone d'une première épaisseur (26) et une zone d'une seconde épaisseur (28), la zone d'une première épaisseur (26) ayant une épaisseur supérieure à celle de la zone d'une seconde épaisseur (28), la zone d'une première épaisseur (26) s'étendant dans la pluralité de textures (18) et la zone d'une seconde épaisseur (28) ne s'étendant pas dans la pluralité de textures (18).

2. Pile de capteurs ultrasonores (10) selon la revendication 1, dans laquelle la zone d'une première épaisseur (26) correspond à une première fréquence et la zone d'une seconde épaisseur (28) correspond à une seconde fréquence, la première fréquence étant supérieure à la seconde fréquence.

3. Pile de capteurs ultrasonores (10) selon la revendication 2, dans laquelle la première fréquence est de 60 MHz et la seconde fréquence est de 40 MHz.

4. Pile de capteurs ultrasonores (10) selon la revendication 1, dans laquelle la zone d'une première épaisseur (26) possède une épaisseur de 3/4λ et la zone d'une seconde épaisseur (28) possède une épaisseur de 1/4λ, λ étant une longueur d'onde souhaitée.

5. Pile de capteurs ultrasonores (10) selon la revendication 1, dans laquelle la couche d'adaptation (16) possède un rapport entre la zone d'une première d'épaisseur et la zone d'une seconde épaisseur supérieur à 1:1.

6. Pile de capteurs ultrasonores (10) selon la revendication 1, dans laquelle la couche d'adaptation (16) possède un rapport entre la zone d'une première épaisseur et la zone d'une seconde épaisseur inférieur à 1:1.

7. Pile de capteurs ultrasonores (10) selon la revendication 1, dans laquelle les textures (18) possèdent chacune une texture de surface de forme circulaire.

8. Pile de capteurs ultrasonores (10) selon la revendication 7, dans laquelle la pluralité de textures (18) est prévue comme une rangée de cercles.

9. Pile de capteurs ultrasonores (10) selon la revendication 1, dans laquelle les textures (18) possèdent chacune une forme de profondeur carrée.

10. Pile de capteurs ultrasonores (10) selon la revendication 1, dans laquelle les textures (18) possèdent chacune une forme de profondeur concave.

11. Pile de capteurs ultrasonores (10) selon la revendication 1, dans laquelle la couche d'adaptation (16) comprend une première couche d'adaptation (16a) et une seconde couche d'adaptation (16b).

12. Pile de capteurs ultrasonores (10) selon la revendication 11, dans laquelle la première couche d'adaptation (16a) définit des extensions (24) qui s'étendent dans la pluralité de textures (18), et la seconde couche d'adaptation (16b) ne s'étend pas dans la pluralité de textures (18).

13. Pile de capteurs ultrasonores (10) selon la revendication 11, dans laquelle la première couche d'adaptation (16a) et la seconde couche d'adaptation (16b) comprennent le même matériau.

14. Pile de capteurs ultrasonores (10) selon la revendication 11, dans laquelle la première couche d'adaptation (16a) et la seconde couche d'adaptation (16b) comprennent un matériau différent.

15. Procédé de fabrication d'une pile de capteurs ultrasonores, qui comprend les étapes qui consistent à :
(a) former une tranche (100) qui comprend les étapes qui consistent à :
(i) prévoir une couche de support (12) ;
(ii) prévoir une couche active (14) qui chevauche la couche de support (12) ;
(iii) former une pluralité de textures (18) sur une surface de la couche active (14) ;
(iv) prévoir une couche d'adaptation (16) par-dessus la surface de la couche active (14), la couche d'adaptation (16) ayant une zone d'une première épaisseur (26) et une zone d'une seconde épaisseur (28), la zone d'une première épaisseur (26) ayant une épaisseur supérieure à celle de la zone d'une seconde épaisseur (28), la zone d'une première épaisseur (26) comprenant des extensions qui s'étendent dans la pluralité de textures (18) et qui remplissent la pluralité de textures (18), et la zone d'une seconde épaisseur (28) ne s'étendant pas dans la pluralité de textures (18) ; et
(b) diviser la tranche (100) en segments, chaque segment formant une pile de capteurs ultrasonores (10).
